# EUROPEAN PATENT APPLICATION

(11) **EP 3 703 238 A1**
(43) Date of publication of application: **02.09.2020**
(21) Application number: 19160066.7
(22) Date of filing: 28.02.2019
(51) Int. Cl.: H02M 7/00

(54) **AN INVERTER FOR A PHOTOVOLTAIC PLANT**

(71) Applicant: ABB Schweiz AG, 5400 Baden (CH)
(72) Inventor: Macerini, Sauro, I-52021 Bucine (AR) (IT)
(74) Representative: De Bortoli, Eros

(57) **Abstract**

An inverter (1) for a photovoltaic plant (700), which comprises:
- a frame structure (3) defining an internal volume and providing mechanical support to one or more components of said inverter;
- an inverter section (1A, 1B) comprising one or more first electronic boards (40), one or more second electronic boards (60) and one or more electromagnetic modules (50) electrically connected with said first and second electronic boards;
Each electromagnetic module (50) is mechanically coupleable with a first electronic board (40) and with one or more supporting members (32) of said frame structure (3).

## Description

The present invention relates to an inverter for a photovoltaic plant.

As is known, an inverter generally comprises a DC section including one or more DC input channels receiving DC electric power from corresponding photovoltaic strings, a DC/AC conversion section providing a DC/AC conversion of DC electric power provided by the photovoltaic strings and an AC section providing AC electric power to an electric power distribution grid, for example the mains.

In many cases, as an example when the inverter is capable of carrying out MPPT (Maximum Power Point Tracking) functionalities, each DC input channel is operatively associated with a filtering circuit operatively coupled with a corresponding DC/DC converter.

From a structural point of view, in the DC section of these inverters it is possible to identify one or more electronic boards on which the filtering circuits operatively associated with the corresponding DC input channels are mounted, one or more electronic boards on which the electronic circuits of the DC/DC converters operatively associated with the corresponding DC input channels are mounted and one or more modules including the power inductors of the DC/DC converters operatively associated with the corresponding DC input channels.

In commonly available inverters for photovoltaic plants, the above-mentioned electronic boards and power inductors are installed in their operating position using arrangements that generally show a poor flexibility in use, as they are mostly bound to the overall number of power inductors to install.

Additionally, said known installation arrangements are relatively cumbersome and entail a huge number of mechanical and electrical connections, which makes them generally complex, time-consuming and expensive to implement at industrial level.

In the state of the art, it is quite felt the demand for technical solutions capable of solving or mitigating the above-mentioned drawbacks.

In order to respond to this need, the present invention provides an inverter, according to the following claim 1 and the related dependent claims.

In a general definition, the inverter, according to the invention, comprises a frame structure defining an internal volume and providing mechanical support to one or more components of the inverter.

The inverter comprises at least an inverter section, which comprises one or more first electronic boards, one or more second electronic boards and one or more electromagnetic modules electrically connected with said first and second electronic boards.

Preferably, the above-mentioned inverter section is at least one between the DC section and the AC section of said inverter.

Preferably, when said inverter section is the DC section of the inverter, said one or more first electronic boards include one or more filtering circuits of said DC section and said one or more second electronic boards include one or more switching conversion circuits of said DC section.

Each electromagnetic module comprises:
- an electromagnetic component, preferably including a power inductor;
- first electric contacts electrically connected with the electromagnetic component and adapted to electrically connect said electromagnetic component with a first electronic board of said inverter section;
- second electric contacts electrically connected with the electromagnetic component and adapted to electrically connect said electromagnetic component with a second electronic board of said inverter section;
- a supporting frame defining a seat for accommodating the electromagnetic component.

The supporting frame comprises one or more first coupling surfaces adapted to mechanically couple with a first electronic board and one or more second coupling surfaces, which are spaced from said first coupling surfaces and are adapted to mechanically couple with one or more supporting members of the frame structure of the inverter.

According to an aspect of the invention, the supporting frame of each electromagnetic module comprises opposite upper and lower walls spaced one from another and comprising said first and second coupling surfaces, respectively.

According to an aspect of the invention, each electromagnetic module comprises first mechanical connection means adapted to couple said supporting frame with said first electronic board at said first coupling surfaces.

According to an aspect of the invention, each electromagnetic module comprises second mechanical connection means adapted to couple its supporting frame with the supporting members of the frame structure of the inverter at said second coupling surfaces.

According to an aspect of the invention, each electromagnetic module comprises third mechanical connection means adapted to couple said first electric contacts with corresponding third electric contacts of said first electronic board.

According to an aspect of the invention, each electromagnetic module comprises fourth mechanical connection means adapted to couple said second electric contacts with corresponding fourth electric contacts of said second electronic board.

According to an aspect of the invention, the supporting frame of each electromagnetic module comprises housing means to define a seat for accommodating said first electric contacts.

According to an aspect of the invention, the supporting frame of each electromagnetic module comprises distinct and mutually coupleable first and second frame portions respectively comprising said first and second coupling surfaces.

According to an aspect of the invention, each electromagnetic module comprises fifth mechanical connection means adapted to mechanically couple said first and second frame portions one with another.

According to an aspect of the invention, the electromagnetic component of each electromagnetic module has a magnetic core and one or more windings wound around said magnetic core.

In a further aspect, the present invention relates to an electromagnetic module for a photovoltaic inverter, according to the following claim 15.

In yet a further aspect, the present invention relates to a photovoltaic plant, according to the following claim 16.

Further characteristics and advantages of the present invention will be more apparent with reference to the description given below and to the accompanying figures, provided purely for explanatory and non-limiting purposes, wherein:
- Fig. 1 schematically illustrates a photovoltaic plant including the inverter, according to the present invention;
- Fig. 1A schematically illustrates the DC section of the inverter, according to the present invention;

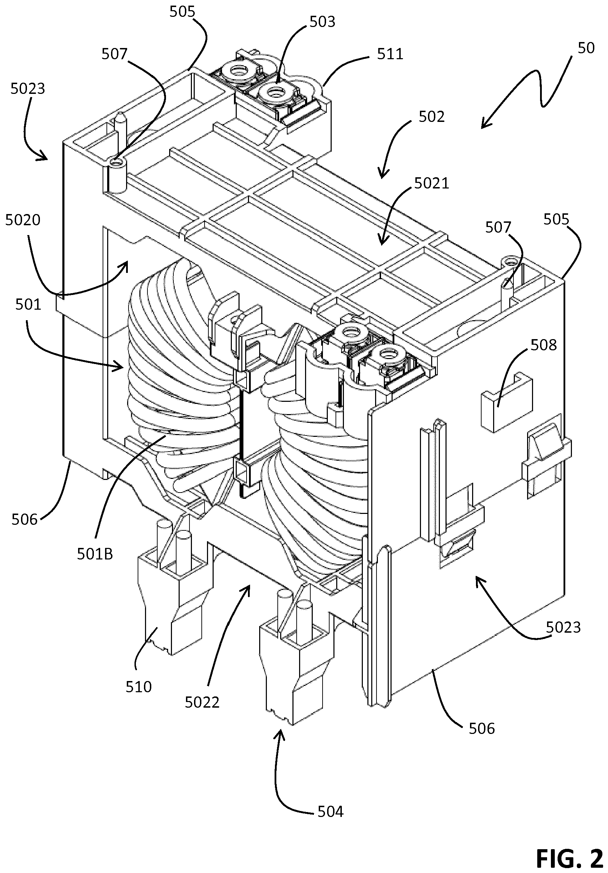

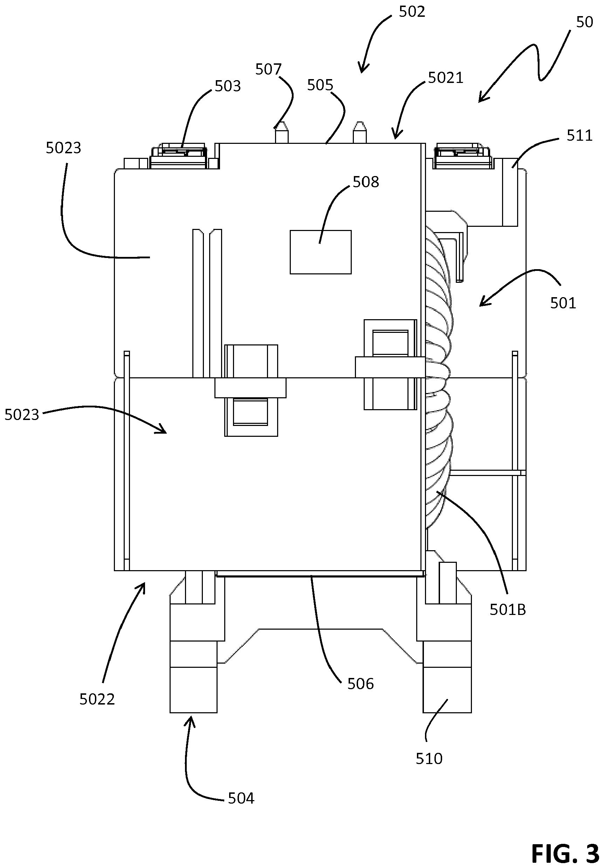

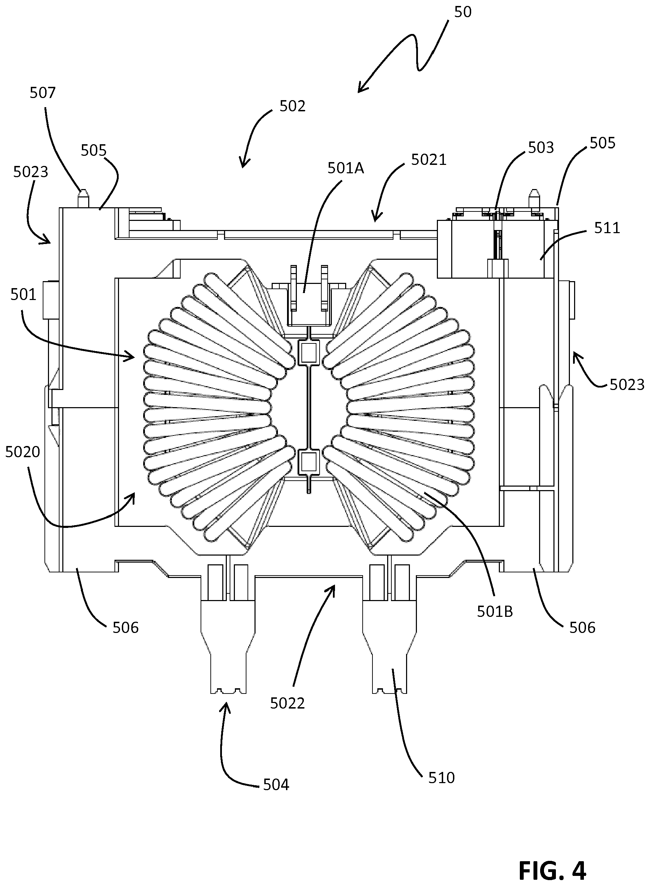

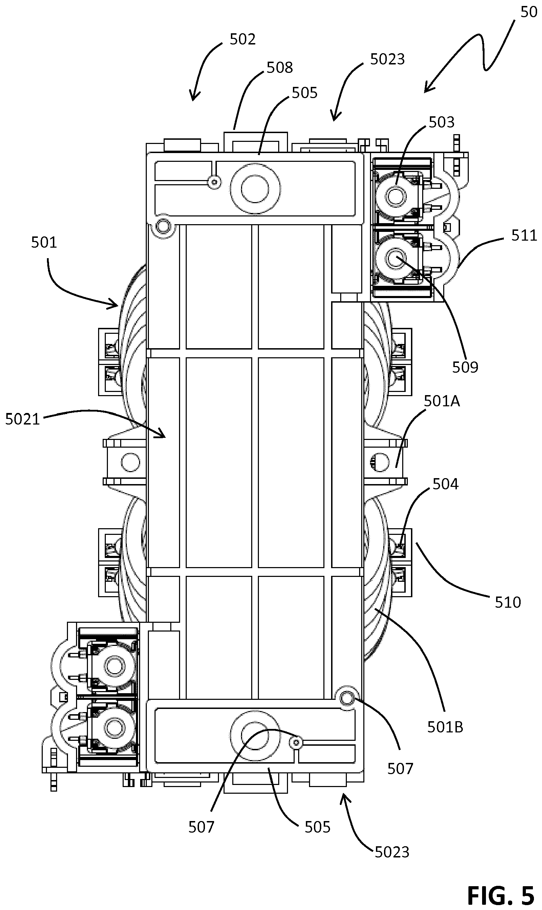

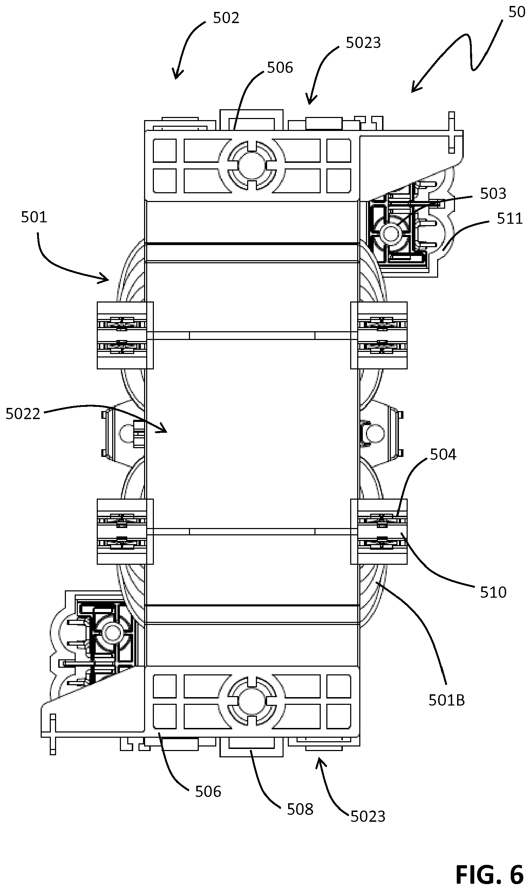

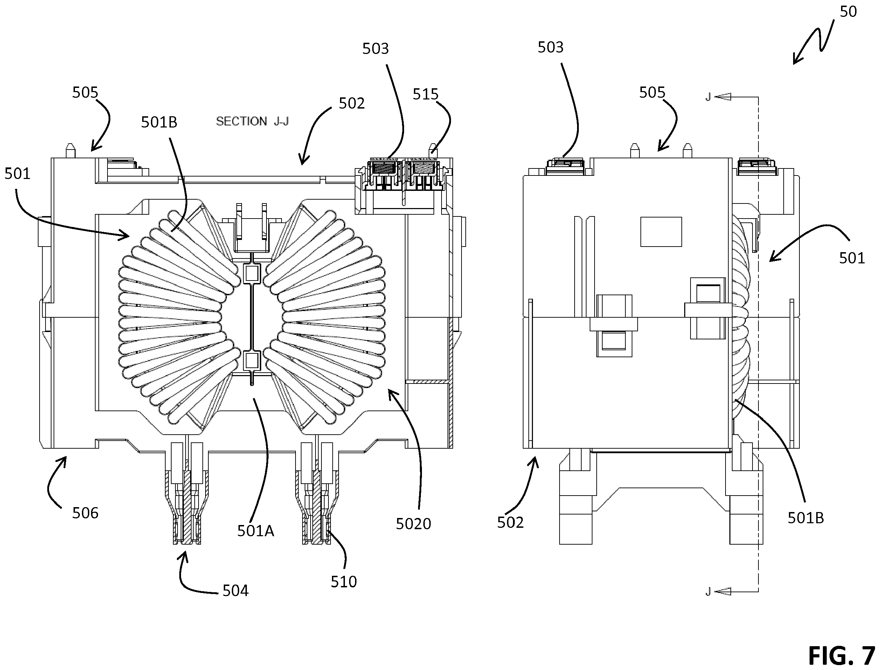

- Figs. 2-10 schematically illustrate different views an electromagnetic module included in the inverter, according to the present invention;
- Figs. 11-12 schematically illustrate different views of the structure of the DC section of an embodiment of the inverter, according to the present invention.

With reference to cited figures, the present invention relates to an inverter 1 for a low voltage photovoltaic plant 700 (also referred to as "photovoltaic inverter" in the following).

For the sake of clarity, it is specified that the term "low voltage" refers to operating voltages lower than 1 kV AC and 2 kV DC.

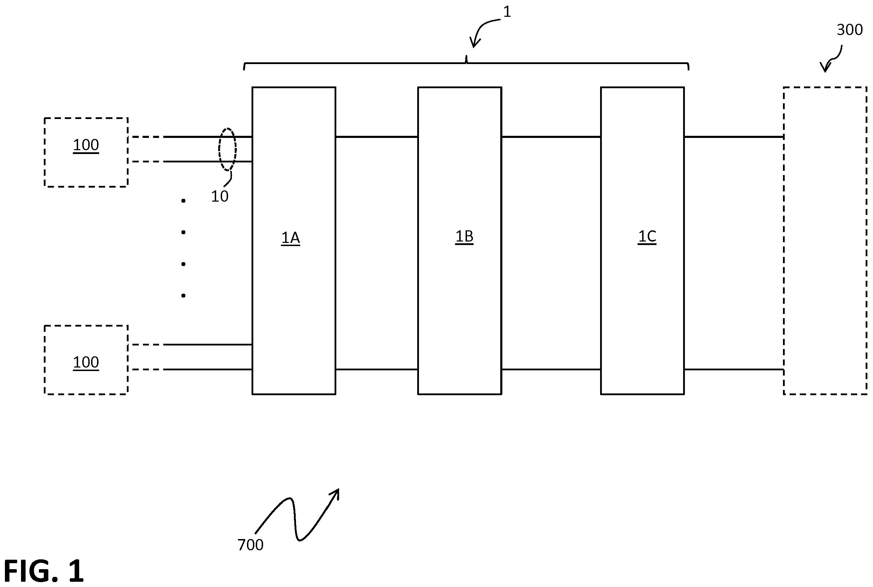

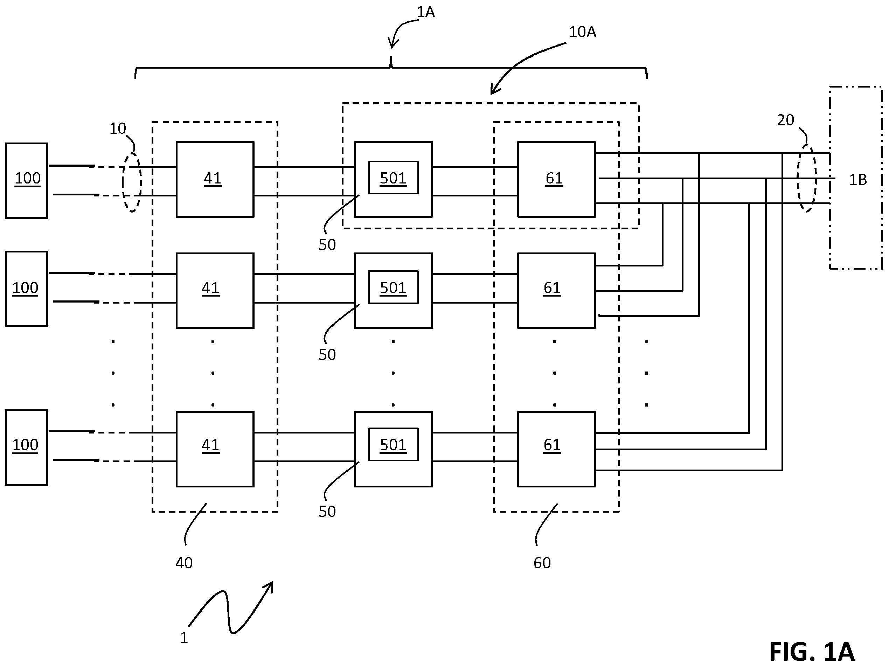

Referring to figure 1, the photovoltaic apparatus 700 including the photovoltaic inverter 1 is schematically shown.

The photovoltaic apparatus 700 comprises one or more photovoltaic strings 100, each of which may comprise one or more photovoltaic panels electrically connected in series one to another by a power bus (not shown).

The photovoltaic strings 100 are electrically connected with the inverter 1 that in turns is electrically connected with an electric power distribution grid 300 (e.g. the mains or a load circuit).

The photovoltaic inverter 1 is generally adapted to manage the DC/AC conversion of DC electric power provided by the photovoltaic strings 100 and deliver the AC electric power so obtained to the AC grid 300.

More specifically, the photovoltaic inverter 1 is adapted to receive DC electric power from the photovoltaic strings, to convert said DC electric power into AC electric power and to provide said AC electric power to the electric power distribution grid 300.

The photovoltaic inverter 1 comprises a DC section 1A, a DC/AC conversion section 1B and an AC section 1C.

The DC section 1A includes a DC bus having one or more DC input channels 10, each of which has an input port adapted to be electrically connected with a corresponding photovoltaic string 100 and an output port electrically connected with the DC/AC conversion section 1B.

As an example, the DC input channels 10 may be designed to convey a DC power in the range of 1-20 kW with voltage levels in the range of 600-2000 V.

For each DC input channel 10, the DC section 1A comprises a filtering circuit 41 adapted to receive and filter an input DC voltage from a corresponding photovoltaic string 100.

Each filtering circuit 41 may comprise, for example, one or more sensors to detect suitable electric quantities (e.g. voltages and currents) at a corresponding DC input channel 10 and a number of electronic components (e.g. inductors and capacitors) arranged to form a suitable low-pass filtering structure.

For each DC input channel 10, the DC section 1A comprises a DC/DC converter 10A adapted to convert said filtered DC voltage in an output DC voltage having a controllable voltage value to be provided to the DC/AC conversion section 1B.

Each DC/DC converter comprises an electromagnetic component (e.g. a power inductor 501) and a power conversion circuit 61.

Each power conversion circuit 61 may comprise, for example, one or more sensors to detect suitable electric quantities (e.g. DC currents and DC voltages) and a number of electronic components (e.g. MOSFETs or BJTs) arranged to form a suitable power switching structure.

The DC/AC conversion section 1B is electrically connected between the DC section 1A and the AC section 1C.

Preferably, the DC/AC conversion section 1B comprises an input port 20 (also referred to as "DC-link") electrically connected in parallel with all the output ports of the DC input channels 10 of the DC section 1A and an output port electrically connected with the AC section 1C

Preferably, the DC/AC conversion section 1B comprises one or more DC/AC converters (not shown) adapted to provide a DC/AC conversion of DC electric power provided by the photovoltaic strings 100 into AC electric power.

Each DC/AC converter comprises an electromagnetic component (e.g. a power inductor) and a power conversion circuit, which may include in turn one or more sensors to detect suitable electric quantities (e.g. currents and voltages) and a number of electronic components (e.g. MOSFETs or BJTs) arranged to form a suitable power switching structure.

Preferably, the DC/AC conversion section 1B comprises one or more filtering circuits (not shown) adapted to suitably filter the AC voltage provided in output by said DC/AC converters.

Each filtering circuit may comprise, for example, one or more sensors to detect suitable electric quantities (e.g. voltages and currents) and a number of electronic components (e.g. inductors and capacitors) arranged to form a suitable band-pass filtering structure.

The AC section 1C is electrically connected with the DC/AC conversion section 1B and the electric power distribution grid 300.

Preferably, the AC section 1C comprises an input port electrically connected with the output port of the DC/AC conversion section 1B and a suitable AC bus adapted to deliver the AC electric power provided by the DC/AC conversion section 1B to the electric power distribution grid 300.

Preferably, the AC section 1C comprises one or more protection circuits (not shown) to disconnect the inverter from the electric power distribution grid 300 in case of faults and additional filtering circuits (not shown), such as LCL and EMI filtering circuits.

Conveniently, the photovoltaic inverter 1 may comprise additional sections, for example a control section operatively associated with the DC section 1A, the DC/AC conversion section 1B and the AC section 1C to control the operation of these latter.

Such a control section may include one or more control boards or units, each of which may include one or more digital processing devices (e.g. microcontrollers, DSPs, and the like) and suitable electronic circuits of digital or analog type.

In general, most of the components/arrangements of the above-mentioned sections 1A, 1B and 1C of the photovoltaic inverter may be of known type and, hereinafter, they will be described only with reference to the aspects of interest of the invention, for the sake of brevity.

According to the invention, the photovoltaic inverter 1 comprises a frame structure 3 that generally defines an internal volume of said inverter and provides mechanical support to the internal components of the inverter.

According to the invention, the photovoltaic inverter 1 comprises an inverter section comprising one or more first electronic boards, one or more second electronic boards and one or more electromagnetic modules electrically connected with said first and second electronic boards.

In general, the above-mentioned inverter section may be any section of the inverter, the above-mentioned first and second electronic boards may include any electronic circuit of said inverter section and said electromagnetic modules may include any electromagnetic component (e.g. power inductor or transformer) of said inverter section.

Preferably, the above-mentioned inverter section may be at least one between the DC section 1A and the AC section 1B of the photovoltaic inverter 1.

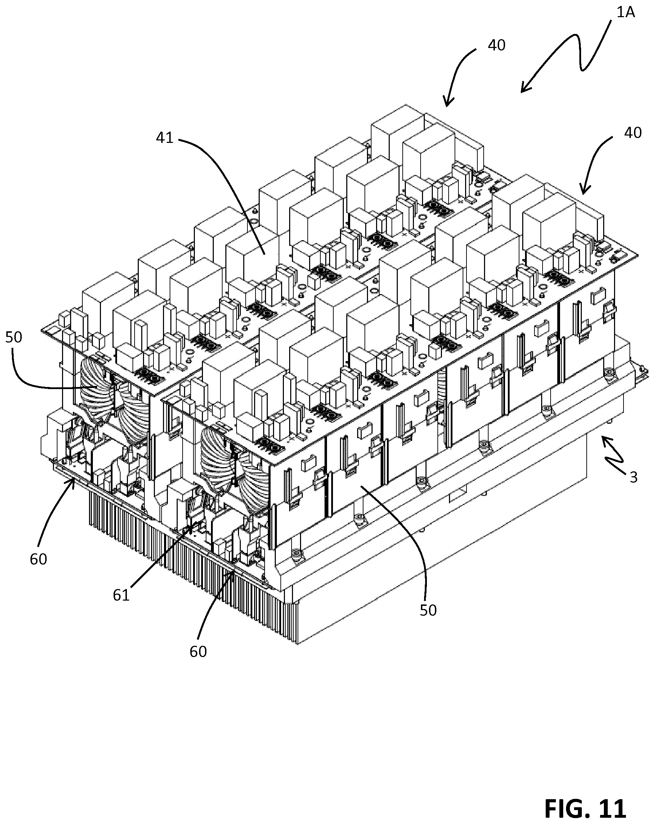

In figures 11-12, there is shown an embodiment of the invention, according to which above-mentioned inverter section is the DC section 1A of the inverter.

In this case:
- the above-mentioned one or more first electronic boards are one or more electronic boards 40 of the DC section 1A on which the filtering circuits 41 of the DC section 1A and, possibly, further electronic components are mounted;
- the above-mentioned one or more second electronic boards are one or more electronic boards 60 of the DC section 1A on which the power conversion circuits 61 of the DC/DC converters 10A and, possibly, further electronic components are mounted;
- the above mentioned one or more electromagnetic modules are one or more electromagnetic modules 50 of the DC section 1A. Each electromagnetic module 50 includes a corresponding electromagnetic component (the power inductor 501) of the DC/DC converters 10A.

According to other embodiments of the invention, which are not necessarily alternative to the embodiment shown in figures 11-12, above-mentioned inverter section is the AC section 1A of the inverter.

In this case:
- the above-mentioned one or more first electronic boards are one or more electronic boards of the AC section 1B on which the filtering circuits of the AC section and, possibly, further electronic components are mounted;
- the above-mentioned one or more second electronic boards are one or more electronic boards of the AC section 1A on which the power conversion circuits of the DC/AC converters and, possibly, further electronic components are mounted;
- the above mentioned one or more electromagnetic modules are one or more electromagnetic modules of the AC section 1B. Each electromagnetic module includes a corresponding electromagnetic component (e.g. a power inductor) of the DC/AC converters of the DC/AC conversion section 1B.

The present invention will be now described in further details with particular reference to the embodiment shown in figures 11-12 for the sake of brevity. However, such a description should not be considered as limitative of the scope of the invention. The features shown in figures 11-12 may be included with suitable adaptations in other sections of the photovoltaic inverter 1, e.g. in the DC/AC conversion section 1B.

According to the embodiment shown in figures 11-12, the frame structure 3 preferably comprises one or more first supporting members 31 and one or more second supporting members 32 adapted to provide a mechanical support to one or more components of the inverter.

Preferably, the first supporting members 31 comprises a supporting plate fixed to additional supporting members (not shown) of the frame structure 3 by suitable mechanical connection means of known type (e.g. screws).

Preferably, the supporting plate 31 comprises a first supporting surface 311, on which the second electronic boards 60 are fixed by suitable mechanical connection means of known type (e.g. screws).

Preferably, the supporting plate 31 is capable of conducting heat and it comprises a second supporting surface 312 (preferably opposite to the first supporting surface 312) on which heat dissipation means 65 of the DC section 1A are fixed by suitable mechanical connection means of known type (e.g. screws).

As shown in figures 11-12, heat dissipation means 65 may include one or more finned heat-dissipating elements adapted to dissipate heat generated by the second electronic boards 60.

Preferably, the second supporting members 32 comprises one or more shaped supporting bars fixed on the first supporting surface 311 of the supporting plate 31 by suitable mechanical connection means of known type (e.g. screws).

Preferably, the second supporting members 32 are adapted to provide mechanical support to the electromagnetic modules 50 of the DC section 1A.

According to the invention, each electromagnetic module 50 comprises an electromagnetic component 501, which preferably has a magnetic core 501A and one or more windings 501B wound around said magnetic core.

Preferably, the magnetic core 501A has a toroid-like shape as shown in the cited figures. However, according to possible variants of the invention, the magnetic core 501A may have different shapes, e.g. a C-like shape or a U-like shape.

Preferably, the electromagnetic component 501 is a power inductor, more preferably the power inductor of a DC/DC converter 10A.

In general, the electromagnetic component 501 may be realized according to industrial techniques of known type and, hereinafter, it will be described only with reference to the aspects of interest of the invention, for the sake of brevity.

According to the invention, each electromagnetic module 50 has its electromagnetic component 501 electrically connected with a first electronic board 40 and a second electronic board 60 and it is arranged in an intermediate volume between said first and second electronic boards.

According to the invention, each electromagnetic module 50 comprises one or more first electric contacts 503 electrically connected with the electromagnetic component 501.

More particularly, each first electric contact 503 is electrically connected with a corresponding terminal (not shown) of a winding 501B of the electromagnetic component 501.

The first electric contacts 503 are adapted to electrically connect the electromagnetic component 501 with a corresponding first electronic board 40.

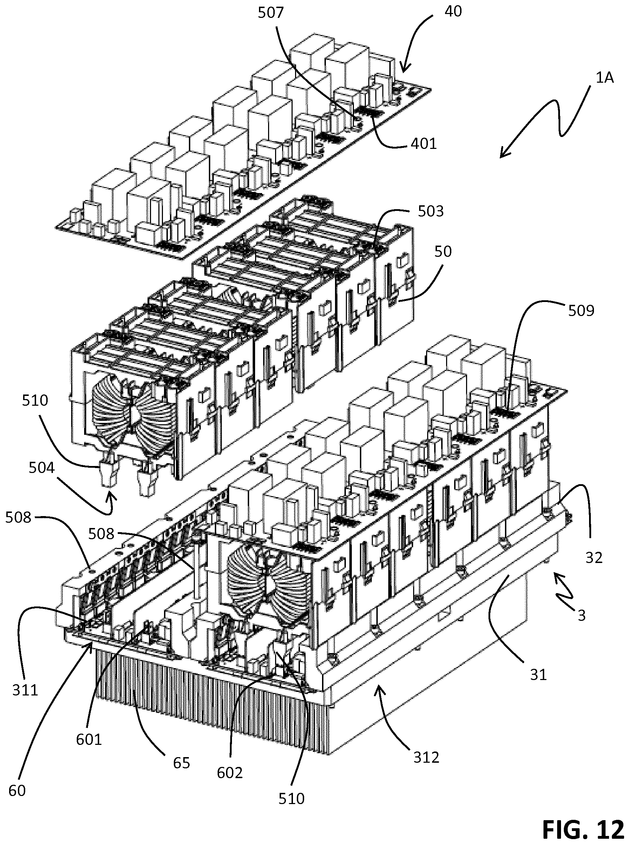

To this aim, the first electric contacts 503 are adapted to be coupled with corresponding third electric contacts 401 of a first electronic board 40 (figure 12).

According to the embodiments shown in the cited figures, each electromagnetic module 50 comprises two pairs of first electric contacts 503 of the ring type. Each first electric contact 503 is electrically connected with a terminal (not shown) of a corresponding winding 501B of the electromagnetic component 501 and electrically connectable of a corresponding pair of third electric contacts 401 of the ring type of a first electronic board 40.

However, the mutually coupleable first electric contacts 503 and third electric contacts 401 may be arranged according to different solutions, depending on the type of electromagnetic component 501, on the number of windings included in this latter and on the type of electrical connections to be arranged between each electromagnetic module 50 and the corresponding first electronic board 40.

According to the invention, each electromagnetic module 50 comprises one or more second electric contacts 504 electrically connected with the electromagnetic component 501.

More particularly, each second electric contact 504 is electrically connected with a corresponding terminal (not shown) of a winding 501B of the electromagnetic component 501.

The second electric contacts 504 are adapted to electrically connect the electromagnetic component 501 with a corresponding second electronic board 60.

To this aim, the second electric contacts 504 are adapted to be coupled with corresponding fourth electric contacts 601 of a second electronic board 60 (figure 12).

According to the embodiments shown in the cited figures, each electromagnetic module 50 comprises four pairs of second electric contacts 504 of the blade type. Each second electric contact 504 is electrically connected with a terminal (not shown) of a corresponding winding 501B of the electromagnetic component 501 and electrically connectable of a corresponding pair of fourth electric contacts 601 of the blade type of a second electronic board 60.

However, the mutually coupleable second electric contacts 504 and fourth electric contacts 601 may be arranged according to different solutions, depending on the type of electromagnetic component 501, on the number of windings included in this latter and on the type of electrical connections to be arranged between each electromagnetic module 50 and the corresponding second electronic boards 60.

According to the invention, each electromagnetic module 50 comprises a supporting frame 502 defining a seat 5020 for accommodating the electromagnetic component 501.

According to the invention, the supporting frame 502 comprises one or more first coupling surfaces 505 mechanically coupleable with a first electronic board 40, in a distal position from the above-mentioned second electronic board 60.

In this way, the supporting frame 502 conveniently provides a mechanical support to the first electronic board 40 and maintains said first electronic board spaced from the second electronic board 60.

According to the invention, the supporting frame 502 comprises one or more second coupling surfaces 506 mechanically coupleable with the supporting means of the frame structure 3, in particular with the above-mentioned second supporting members 32 of the frame structure 3.

In this way, the supporting frame 502 is mechanically supported by the frame structure 3, namely by the second supporting members 32 thereof.

Preferably, the supporting frame 502 comprises a box-like structure that is open at its front and rear sides.

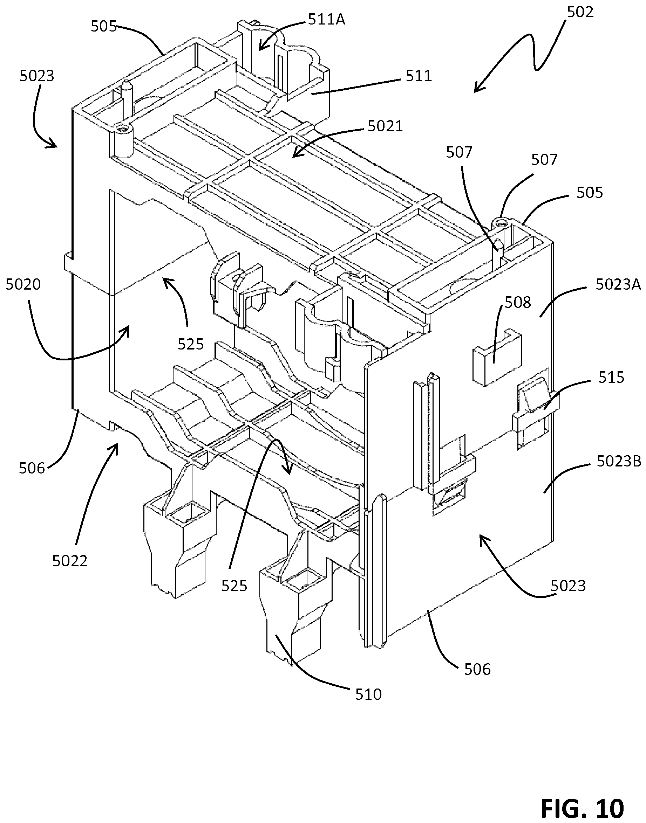

More particularly, the supporting frame 502 preferably comprises opposite upper and lower walls 5021 and 5022, which are arranged spaced, respectively, at a distal position and proximal position from the above-mentioned second electronic board 60, when the electromagnetic module 50 is installed in its normal operating position as shown in figures 10-11.

Preferably, the upper and lower walls 5021 and 5022 are arranged parallel one to another. Preferably, the upper and lower walls 5021 and 5022 are arranged perpendicular to the opposite upper and lower walls 5021 and 5022.

Preferably, the supporting frame 502 further comprises a pair of opposite lateral walls 5023, which are mutually spaced and arranged in such a way to join the upper and lower walls 5021 and 5022

Preferably, the lateral walls 5023 are arranged parallel one to another.

Preferably, the above-mentioned upper, lower and lateral walls 5021, 5022 and 5023 have internal surfaces 5025 (mutually facing two by two), which are conveniently shaped in such a way to define the seat 5020 accommodating the electromagnetic component 501. To this aim, the internal surfaces 5025 are conveniently provided with suitably shaped protruding ribs to hold the electromagnetic component 501 in its operating position (figure 10).

Preferably, the above-mentioned upper and lower walls 5021 and 5022 include the above-mentioned first and second coupling surfaces 505 and 506. In this way, the first and second electronic boards 40, 60 can lay spaced one from another, preferably along parallel planes.

Preferably, the electromagnetic module 50 comprises first mechanical connection means 507 adapted to couple the supporting frame 50 with the first electronic board 40 at the first coupling surfaces 505.

In the cited figures, the first mechanical connection means 507 comprise connection pins of the supporting frame 502 coupleable with corresponding connection holes of the electronic board 40, in which said connection pins are inserted, and connection holes of the supporting frame 502 and coupleable with corresponding connection holes of the electronic board 40, in which connection screws are inserted.

However, according to possible variants of the invention, the first mechanical connection means 507 may be of different types, according to the needs.

Preferably, the electromagnetic module 50 comprises second mechanical connection means 508 adapted to couple the supporting frame 50 with the frame structure 3 (namely with the second supporting members 32) at the second coupling surfaces 506.

In the cited figures, the second mechanical connection means 508 comprise shaped engaging protrusions of the supporting frame 502 coupleable with corresponding connection holes of the supporting beams 32, in which further connection screws are inserted.

However, according to possible variants of the invention, the second mechanical connection means 508 may be of different types (e.g. snap-fit connectors), according to the needs.

Preferably, the electromagnetic module 50 comprises third mechanical connection means 509 adapted to couple the first electric contacts 503 with the corresponding third electric contacts 401 of the first electronic board 40 (figure 12).

In the cited figures, the third mechanical connection means 509 comprise connection screws adapted to be inserted through the ring shaped electric contacts 503 and 401.

However, according to possible variants of the invention, the third mechanical connection means 509 may be of different types (e.g. snap-fit connectors), according to the needs.

Preferably, the electromagnetic module 50 comprises fourth mechanical connection means 510 adapted to couple the second electric contacts 504 with the corresponding fourth electric contacts 601 of the second electronic board 60.

In the cited figures, the fourth mechanical connection means 510 comprise shaped plug elements of the supporting frame 502, which protrude from the lower wall 5022 of this latter and which conveniently house the second electric contacts 504.

Each plug element 510 defines a seat in which the second electric contacts 504 are accommodated and mechanically coupled with the walls of said plug element through a shape or snap-fit mechanical coupling.

The plug elements 510 are conveniently coupleable with corresponding suitable socket elements 602 of the second electronic board 60, preferably through a mechanical connection of the shape-coupling type or snap-fit type.

This solution is quite advantageous as it allows obtaining a robust screw-less coupling between the electric contacts 504 and 601, which remarkably facilitates the installation of the electromagnetic modules 50.

Additionally, such a solution facilitates the installation of second first electric contacts 504 on the supporting frame 502 (e.g. through a simple manual operation) and it ensures an easy access to the electric contacts 503 to electrically couple these latter with the third electric contacts 401 of a first electronic board 40.

Preferably, the supporting frame 502 comprises housing means 511 adapted to define one or more seats 511A to house the first electric contacts 503.

In the cited figures, the housing means 511 comprises one or more shaped protrusions protruding from the upper wall 5021 of the supporting frame 502, preferably at opposite front and rear sides of this latter (reference is made to a normal operating position of the as shown in the cited figures).

The protrusions 511 are conveniently cup-shaped to define a volume in which the first electric contacts 503 are accommodated and mechanically coupled with the walls of the cup-shaped protrusions 511 though a shape or snap-fit mechanical coupling.

This solution is quite advantageous as it facilitates the installation of the first electric contacts 503 on the supporting frame 502 (e.g. through a simple manual operation) and it ensures an easy access to the electric contacts 503 to electrically couple these latter with the third electric contacts 401 of a first electronic board 40.

According to some embodiments of the invention, the supporting frame 502 may be formed by a shaped monolithic body, e.g. fabricated in an electrically insulating material.

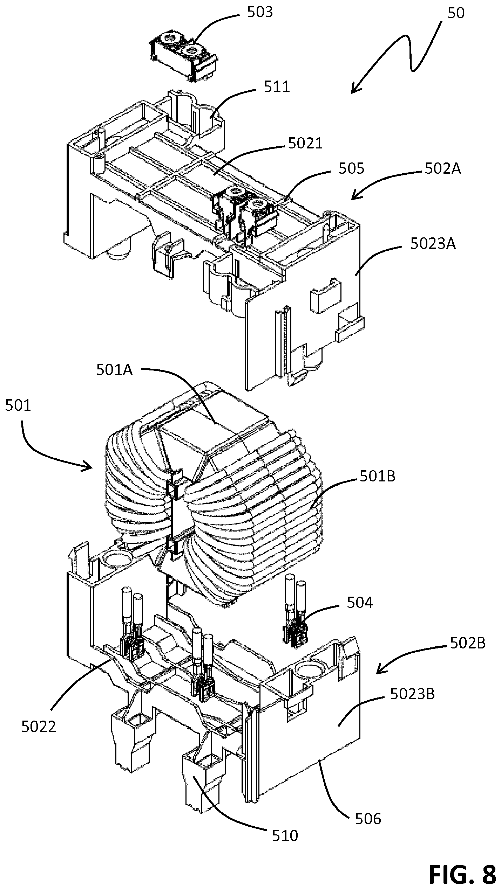

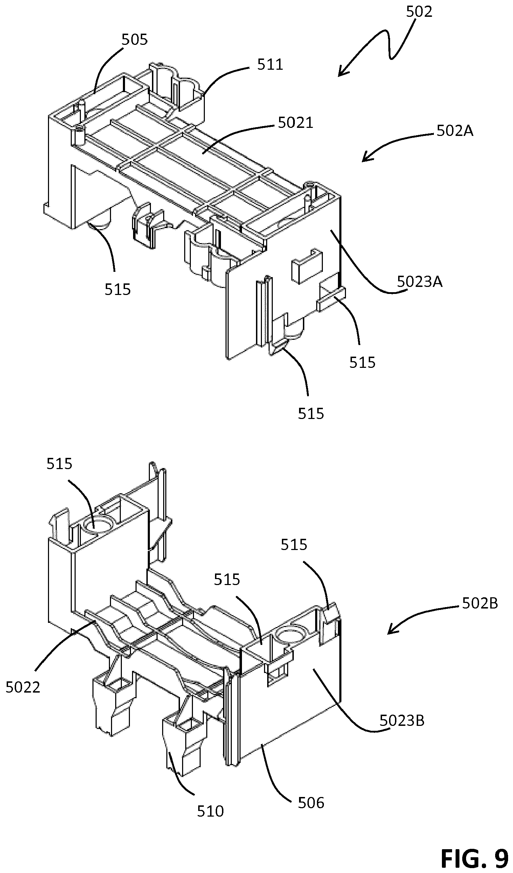

According to other embodiments of the invention shown in the cited figures, however, the supporting frame 502 is formed by multiple portions (e.g. fabricated in an electrically insulating material) that can be assembled together (figures 8-10).

Preferably, the supporting frame 502 comprises distinct first and second frame portions 502A and 502B that respectively comprise the above-mentioned first and second coupling surfaces 505 and 506.

As shown in the cited figures, the first frame portion 502A may include the upper wall 5021 and first wall portions 5023A of the lateral walls 5023, which are joined to the upper wall 5021, whereas the second frame portion 502B may include the lower wall 5022 and second wall portions 5023B of the lateral walls 5023, which are joined to the lower wall 5022.

Preferably, the electromagnetic module 50 comprises fifth mechanical connection means 515 to mechanically couple the first and second portions 502A, 502B one with another.

According to the embodiments shown in the cited figures, the fifth mechanical connection means 515 comprise shaped protrusions and holes of the lateral wall portions 5023A, 5023B, which have a complementary shape and can be mutually joined by means to a shape coupling, and engageable wings and recesses of the wall portions 5023A, 5023B that can be mutually coupled by means to a snap-fit coupling.

However, according to possible variants of the invention, the fifth mechanical connection means 515 may be of different types (e.g. screws), according to the needs.

Figures 1, 11, 12 show a schematic view of the DC section 1A of the photovoltaic inverter 1. A frame structure 3 includes the first and second supporting members 31, 32 to mechanically support the electronic boards 60 and the electromagnetic modules 50.

The DC section 1A comprises twelve input channels 10, which are intended to be electrically connected with corresponding photovoltaic strings 100 of a photovoltaic plant.

The DC section 1A comprises twelve filtering circuits 41, each electrically connected with a corresponding input channel 10.

The DC section 1A comprises two first electronic boards 40, in which the filtering circuits 41 are mounted (six filtering circuits for each electronic board 40).

Each first electronic board 40 comprises third electric contacts 401 for electrical connection with the electromagnetic modules 50 (four pairs of electric contacts 401 for each filtering circuit 41).

The DC section 1A comprises twelve power conversion circuits 61, each electrically connected with the input port 20 of the AC section 1B.

The DC section 1A comprises two second electronic boards 60, in which the power conversion circuits 61 are mounted (six power conversion circuits for each electronic board 60).

Each second electronic board 60 comprises four electric contacts 601 for electrical connection with the electromagnetic modules 50 (four pairs of electric contacts 601 for each power conversion circuit 61).

The DC section 1A comprises twelve electromagnetic modules 50, each having an electromagnetic component 501, a supporting frame 502, first electric contacts 503 for electrical connection with a first electronic board 40 and second electric contacts 504 for electrical connection with a second electronic board 60.

The DC section 1A comprises six electromagnetic modules 50 for each first electronic board 40 and second electronic board 60.

Each electromagnetic module 50 is electrically connected to a corresponding filtering circuit 41 by suitably coupling the first electric contacts 503 with the corresponding third electric contacts 401.

Each electromagnetic module 50 is electrically connected to a corresponding power conversion circuit 61 by suitably coupling the second electric contacts 504 with the corresponding fourth electric contacts 601.

The assembly of each electromagnetic module 50 with the corresponding power conversion circuit 61 forms a DC/DC converter 10A related to a corresponding DC input channel 10.

Each electromagnetic module 50 has thus a number of first electric contacts 503 corresponding to the number of third electric contacts 401 and a number of second electric contacts 504 corresponding to the number of fourth electric contacts 601, respectively.

At its first coupling surfaces 505, each electromagnetic module 50 mechanically supports a corresponding first electronic board 40 whereas, at its second coupling surfaces 506, each electromagnetic module 50 is mechanically supported by a pair of supporting members 32 of the frame structure 3.

The present invention provides relevant advantages with respect to the technical solutions of the state of the art.

As it is possible to notice, an inverter section of the inverter 1 (e.g. the DC section 1A) may be realized according to a fully modular structure, which can be easily designed depending on the electric characteristics of the inverter.

The number of electronic boards 40, 60 and of electromagnetic modules 50 to be employed can thus be easily designed depending on the electrical characteristics of the inverter.

The electromagnetic modules 50 can be directly mounted one by one on supporting elements of the frame structure 3 of the inverter.

This allows achieving a sturdy mechanical coupling between relatively heavy components such as the electromagnetic modules 50 and the supporting frame structure 3 of the inverter. The electromagnetic modules 50 are adapted to provide themselves the mechanical support for the first electronic boards 40.

In particular, the supporting frame 502 of each electromagnetic module 50 is conveniently designed in such way that the electromagnetic modules 50 form, as a whole, an additional internal supporting structure that defines suitable laying plans on which the first electronic boards 40 may be suitably arranged and at, the same time, defines a suitable space for arranging the second electronic boards 60.

An inverter section (e.g. the DC section 1A) may thus be realized with an overall "sandwich" structure that has a compact size and allows achieving remarkable space savings.

The above-mentioned features provide relevant advantages in terms of size reduction and simplification of internal structure of the inverter with respect to known solutions of the state of the art.

An inverter section (e.g. the DC section 1A) may thus be easily assembled in a modular manner without particular mechanical constraints, as the electromagnetic modules 40 and the first electronic boards 40 can be installed according to a so-called "plug & play" approach without the need of additional supporting structures as it occurs in conventional solutions of the state of the art

The inverter 1 shows a compact and robust structure that can be assembled with a relatively small number of operations. The inverter 1 is thus particularly easy and cheap to implement at industrial level.

## Claims

1. An inverter (1) for a photovoltaic plant (700), said inverter comprising:
- a frame structure (3) defining an internal volume and providing mechanical support to one or more components of said inverter;
- an inverter section (1A, 1B) comprising one or more first electronic boards (40), one or more second electronic boards (60) and one or more electromagnetic modules (50) electrically connected with said first and second electronic boards;
**characterised in that** an electromagnetic module (50) comprises:
- an electromagnetic component (501);
- first electric contacts (503) electrically connected with said electromagnetic component (501) and adapted to electrically connect said electromagnetic component with a first electronic board (40) of said inverter section;
- second electric contacts (504) electrically connected with said electromagnetic component (501) and adapted to electrically connect said electromagnetic component with a second electronic board (60) of said inverter section;
- a supporting frame (502) defining a seat (5020) for accommodating said electromagnetic component,
wherein said supporting frame comprises one or more first coupling surfaces (505) mechanically coupleable with said first electronic board (40),
wherein said supporting frame comprises one or more second coupling surfaces (506) spaced from said first coupling surfaces (505) and mechanically coupleable with one or more supporting members (32) of said frame structure (3).

2. An inverter, according to claim 1, **characterised in that** said supporting frame (502) comprises opposite upper and lower walls (5021, 5022) spaced one from another and comprising said first and second coupling surfaces (505, 506), respectively.

3. An inverter, according to one or more of the previous claims, **characterised in that** said electromagnetic module (50) comprises first mechanical connection means (507) adapted to couple said supporting frame (502) with said first electronic board (40) at said first coupling surfaces (505).

4. An inverter, according to one or more of the previous claims, **characterised in that** said electromagnetic module (50) comprises second mechanical connection means (508) adapted to couple said supporting frame (502) with said supporting members (32) at said second coupling surfaces (506).

5. An inverter, according to one or more of the previous claims, **characterised in that** said electromagnetic module (50) comprises third mechanical connection means (509) adapted to couple said first electric contacts (503) with corresponding third electric contacts (401) of said first electronic board (40).

6. An inverter, according to one or more of the previous claims, **characterised in that** said electromagnetic module (50) comprises fourth mechanical connection means (510) adapted to couple said second electric contacts (504) with corresponding fourth electric contacts (601) of said second electronic board (60).

7. An inverter, according to one or more of the previous claims, **characterised in that** said supporting frame (502) comprises housing means (511) to define a seat (511A) for accommodating said first electric contacts (503).

8. An inverter, according to one or more of the previous claims, **characterised in that** said supporting frame (502) comprises distinct and mutually coupleable first and second frame portions (502A, 502B) respectively comprising said first and second coupling surfaces (505, 506).

9. An inverter, according to claim 8, **characterised in that** said electromagnetic module (50) comprises fifth mechanical connection means (515) to mechanically couple said first and second frame portions (502A, 502B) one with another.

10. An inverter, according to one or more of the previous claims, **characterised in that** said electromagnetic component (501) has a magnetic core (501A) and one or more windings (501B) wound around said magnetic core.

11. An inverter, according to claim 10, **characterised in that** said electromagnetic component (501) is a power inductor.

12. An inverter, according to one or more of the previous claims, **characterised in that** said inverter section is a DC section (1A) of said inverter.

13. An inverter, according to claim 12, **characterised in that** said one or more first electronic boards (40) include one or more filtering circuits of said DC section (1A) and said one or more second electronic boards (60) include one or more power conversion circuits of said DC section.

14. An inverter, according to one or more of the previous claims, **characterised in that** said inverter section is an AC section (1B) of said inverter.

15. An electromagnetic module (50) for an inverter (1) **characterised in that** it comprises:
- an electromagnetic component (501);
- first electric contacts (5021) electrically connected with said electromagnetic component (501) and adapted to electrically connect said electromagnetic component with a first electronic board (40) of an inverter section (1A, 1B) of said inverter;
- second electric contacts (5022) electrically connected with said electromagnetic component (501) and adapted to electrically connect said electromagnetic component with a second electronic board (60) of said inverter section (1A, 1B);
- a supporting frame (502) defining a seat (5020) for accommodating said electromagnetic component,
wherein said supporting frame comprises one or more first coupling surfaces (505) mechanically coupleable with said first electronic board (40),
wherein said supporting frame comprises one or more second coupling surfaces (506) spaced from said first coupling surfaces (505) and mechanically coupleable with one or more supporting members (32) of said frame structure (3).

16. A photovoltaic plant (700) **characterised in that** it comprises an inverter (1), according to one of more of the claims from 1 to 14.
